# EUROPÄISCHE PATENTSCHRIFT

(11) **EP 0 863 435 B1**
(45) Veröffentlichungstag und Bekanntmachung des Hinweises auf die Patenterteilung: **14.11.2001**
(21) Anmeldenummer: 98103538.9
(22) Anmeldetag: 28.02.1998
(51) Int. Cl.: G03F 1/00

(54) **Material und Verfahren zum Kantenabdecken von photopolymerisierbaren Druckplatten für den Flexodruck**
Material and process for covering the edges of photopolymerizable printing plates for flexographic printing
Matériau et procédé pour couvrir des faces de clichés photopolymérisables pour l'impression flexographiques

(30) Priorität: 06.03.1997 DE 19709037
(43) Veröffentlichungstag der Anmeldung: 09.09.1998
(73) Patentinhaber: DU PONT DE NEMOURS (DEUTSCHLAND) GMBH, 61343 Bad Homburg v.d.H. (DE)
(72) Erfinder: Alince, Wolgang, Dr., 63263 Neu-Isenburg (DE); Dudek, Dietmar, Dr., 63225 Langen (DE)

(56) Entgegenhaltungen:
- EP-A- 0 568 841
- DE-C- 3 514 768
- DE-C- 3 744 243
- GB-A- 1 284 296

## Beschreibung

Die Erfindung betrifft ein Verfahren zur Herstellung von Flexodruckformen wobei Lasermaskenbeschichtungen enthaltende photopolymerisierbare Druckplatten auf Sleeves bwz. Zylindern vormontiert werden, die Lasermasken hergestellt werden, die photopolymerisierbaren Druckplatten durch diese Lasermasken belichtet werden und die so belichteten Druckplatten ausgewaschen und getrocknet werden.

Es ist bekannt, für die Herstellung von flexographischen Druckformen photopolymerisierbare Druckplatten zu verwenden, bei denen die Druckoberfläche durch bildmäßiges Belichten durch eine Photovorlage einer durch aktinische Strahlung photopolymerisierbaren Schicht und anschließendes Entfernen der unbelichteten, nicht photopolymerisierten Druckplattenbereiche erzeugt wird. Beispiele hierfür finden sich in den folgenden Patenten: DE-C 22 15 090, der EP-A 0 322 585 und der US-A 4,323,636.

Zur bildmäßigen Belichtung der photopolymerisierbaren Druckplatten wird eine Photovorlage benötigt, die eine Maske mit transparenten und opaken Bereichen in Form des wiederzugebenden Bildes darstellt. Diese Photovorlage ist gewöhnlich ein photographisches Negativ des zu druckenden Bildes. Falls Korrekturen am endgültigen Bild notwendig sind, muß eine neue Photovorlage hergestellt werden. Auch kann ein und dieselbe Photovorlage je nach Verarbeitungsbedingungen (Temperatur, Feuchtigkeit) unterschiedliche Ergebnisse liefern, so daß Registrierprobleme bei der Druckformmontage auftreten können. Um dieses zeit- und kostenintensive Verfahren zu vereinfachen, werden photopolymerisierbare Druckplatten mit einer zusätzlichen Schicht versehen, die zu einer integrierten Photovorlage verarbeitet werden kann. Solche Materialien mit IR-abschmelzbaren, UV-absorbierenden Schichten und Verfahren zu ihrer Herstellung und Verarbeitung werden in WO 94/03838, WO 94/03839 und WO 96/16356 beschrieben. Die Herstellung der integrierten Photomaske erfolgt durch Laserbelichtung.

Die Entwicklung solcher Materialien zielt neben der direkten Verarbeitung digitaler Bildinformationen und höherer Auflösung der resultierenden Flexodruckformen auch auf eine deutliche Vereinfachung der registergetreuen Herstellung von Zylinderhülsen, sog. Sleeves, und Zylindern. Dies erfolgt durch die in etwa Montage von Abschnitten der laserbeschreibbaren, photopolymerisierbaren Flexodruckplatten auf dem Sleeve bzw. Zylinder. Die Plazierung der Abschnitte kann mit einer sehr großen Toleranz erfolgen, da die registergenaue Ausrichtung der später druckenden Bildelemente durch die Belichtung mit dem präzise geführten Laserkopf erfolgt. So beschriebene Sleeves bzw. Zylinder werden anschließend in einem Rundbelichter UV-belichtet und dann ausgewaschen. Leider bleiben an den Kanten der Plattenabschnitte polymerisierte Stege stehen, die später unerwünschterweise ebenfalls mitdrucken würden.

Bei der Herstellung druckfertiger Zylinder bzw. Sleeves, aus konventionell gefertigten Flexodruckplattenabschnitten ist es möglich, unerwünschte Stege, die durch die Belichtung von Druckplattenkanten entstehen, vor der Montage zu entfernen, da diese Platten vor der Montage geschnitten werden können.

Es besteht zwar auch bei laserbearbeitbaren Druckplatten die Möglichkeit der nachträglichen Entfernung der unerwünschten Stege, z.B. durch Schneiden mit scharfen Messern. Jedoch ist diese Maßnahme sehr zeitaufwendig, die Gefahr der Zerstörung der Druckformen ist sehr groß, insbesondere wenn die Motive bis nahe an die Druckformenkanten herangeführt sind, und das rückstandsfreie Entfernen der abgeschnittenen Stege ist sehr aufwendig.

Der vorliegenden Erfindung lag daher die Aufgabe zugrunde, die Nachteile des Standes der Technik zu vermeiden und die beim Verarbeiten von laserbearbeitbaren, flexographischen Druckplatten im Rundbelichter auftretenden Stege zuverlässig, schnell und einfach zu verhindern.

Diese Aufgabe wurde überraschenderweise gelöst durch ein Verfahren zur Herstellung von Flexodruckformen wobei a) Lasermaskenbeschichtungen enthaltende photopolymerisierbare Druckplatten auf Sleeves bwz. Zylindern vormontiert werden, b) die Lasermasken hergestellt werden, c) die photopolymerisierbaren Druckplatten durch diese Lasermasken belichtet werden und d) die so belichteten Druckplatten ausgewaschen und getrocknet werden, dadurch gekennzeichnet, daß vor der Herstellung der Lasermasken b) oder vor der bildmäßigen Belichtung der photopolymerisierbaren Druckplatten c) ein Kantenabdeckmaterial, enthaltend mindestens ein lösliches, filmbildendes Polymer, mindestens einen UV-Absorber und ein Lösemittel oder ein Lösemittelgemisch, auf die Kanten der photopolymerisierbaren Druckplatten aufgebracht wird, und durch photopolymerisierbare Flexodruckplatten enthaltend solch ein Kantenabdeckmaterial.

Überraschenderweise werden durch das erfindungsgemäße Verfahren und die erfindungsgemäßen Kantenabdeckmaterialien Druckplattenkanten, auch dickerer Flexodruckplatten, vollständig abgedeckt. Somit kann die Belichtung der Kanten verhindert und die hierdurch hervorgerufenen unerwünschten Stege können vermieden werden.

Die erfindungsgemäßen Polymerlösungen zur Behandlung der Druckplattenkanten werden durch Auflösen der löslichen, filmbildenden Polymere und der UV-Absorber in organischen Lösemitteln hergestellt.

Als Polymere können alle bekannten löslichen, filmbildenden Polymere verwendet werden, bevorzugt solche, die sich im Auswaschlösemittel für die belichteten Druckplatten gut lösen. Insbesondere werden die polymeren Bindemittel der zu belichtenden Druckplatte verwendet. Besonders geeignet sind thermoplastisch elastomere Blockcopolymere, wie sie z.B. in der DE-C 22 15 090, der EP-A 0 322 585 und der US 4,323,636 beschrieben sind. Insbesondere lineare und radiale Blockcopolymere mit Polystyrolendblöcken wie z.B. Polystyrol-Polybutadien-Polystyrol, (Polystyrol-Polybutadien)4 Si oder die entsprechenden Isoprenpolymere sind als Bindemittel geeignet. Das mittlere Molekulargewicht Mn der Blockcopolymere liegt üblicherweise zwischen80000 und 300000, bevorzugt zwischen 100000 und 250000. Ein Polystyrolanteil von 10 - 40 Gew.-% ist vorteilhaft, vor allem ein Anteil von 15 - 30 Gew.-%.

Wählt man als lösliche, filmbildende Polymere Bindemittel, die gleichzeitig als Flexodruckplattenbestandteile in der zu behandelnden Druckplatte verwendet werden, so wird gesichert, daß das erfindungsgemäße Kantenabdeckmaterial im Auswaschprozeß der belichteten Druckplatte rückstandsfrei entfernt wird.

Als UV-Absorber können Verbindungen verwendet werden, deren Absorption im Bereich von 300 bis 400 nm, bevorzugt bei 360 nm, liegt. Besonders geeignet sind Verbindungen, die zu den filmbildenden Polymeren kompatibel sind. Typische Beispiele sind Benzophenolderivate wie z. B. 2,2'-Dihydroxy-4,4'-dimethoxy-benzophenol, Benzotriazol oder Benzotriazolderivate. Insbesondere Benzotriazolderivate wie z. B. 2-(2-Hydroxy-3,5-di-tert.amyl-phenyl)-2H-benztriazol werden bevorzugt.

Als Lösemittel können übliche Gießlösemittel der Druckplattenherstellung verwendet werden. Insbesondere eignen sich leicht verdampfbare Lösemittel, die zudem ein hohes Lösevermögen für das filmbildende Polymer haben. Durch geeignete Wahl des organischen Lösemittels wird ein An- bzw. Ablösen der Laserschicht vermieden. Bevorzugt werden Toluol, Xylol, Methylethylketon und Essigsäureethylester und deren. Mischungen verwendet.

Gegebenenfalls enthalten die erfindungsgemäßen Kantenabdeckmaterialien zusätzlich ein Thixotropiermittel. Dies ermöglicht auch bei dicken Druckplatten eine zuverlässige Abdeckung der oberen Partien der Kanten. Alle gängigen Thixotropiermittel wie z. B. Bentonite, Kaoline und Kieselsäuren können verwendet werden. Besonders geeignet sind pyrogene Kieselsäuren.

Außerdem können auch Farbstoffe und/oder Pigmente in den Kantenabdeckmaterialien enthalten sein. Geeignet sind alle bekannten Farbstoffe und Pigmente. Als Beispiele seien genannt: anorganische und organische Pigmente, Kohlenstoff, Metall-Phthalocyanine, Azofarbstoffe, etc. Bevorzugt werden Metall-Phthalocyanine, insbesondere Zapon Blau 807 (C.I. 74400) verwendet.

Über den Feststoffgehalt und/oder den Gehalt an Thixotropiermittel wird eine geeignete Viskosität der erfindungsgemäßen Kantenabdeckmaterialien eingestellt, die ein gleichmäßiges Auftragen auf die Seitenkanten der photopolymerisierbaren Druckplatten erlaubt und zur Ausbildung eines möglichst gleichmäßigen dicken Films an diesen Stellen führt. Tropfenbildung und Verfließen werden so vermieden. Die Viskosität beträgt bevorzugt 1 - 3 Pa·s.

Das Aufbringen der erfindungsgemäßen Kantenabdeckmaterialien auf die Druckplattenkanten erfolgt mit dem Fachmann geläufigen Methoden, wie Verstreichen, Sprühen, etc., bevorzugt durch Auftragen mit einer feine Düse.

Ein besonderer Vorteil des erfindungsgemäßen Materials und Verfahrens ist, daß es für eine Vielzahl der bekannten Plattenmaterialien angewendet werden kann, und es so möglich ist, die Qualität von flexographischen Druckformen und der mit ihnen hergestellten Drucke erheblich zu verbessern ohne kostspielige und aufwendige Maßnahmen ergreifen zu müssen.

Das vorliegende Material und Verfahren kann für photopolymerisierbare Druckplatten angewendet werden, die mindestens ein polymeres Bindemittel, mindestens eine durch aktinische Strahlung additionspolymerisierbare ethylenisch ungesättigte Verbindung und einen Photoinitiator oder ein Photoinitiatorsystem enthalten und die ohne zusätzliche Photovorlage bildmäßig belichtet werden können. Solche, im Sinne der vorliegenden Erfindung geeigneten, Materialien sind insbesondere die in WO 94/03838, WO 94/03839 und WO 96/16356 beschrieben Materialien mit IR-abschmelzbaren, UV-absorbierenden Schichten zur Herstellung von integrierten Photomasken. Verfahren zu ihrer Herstellung und Verarbeitung werden ebenfalls in WO 94/03838, WO 94/03839 und WO 96/16356 beschrieben.

Die folgenden Beispiele sollen die vorliegende Erfindung verdeutlichen. Die angegebenen Teile und Prozente beziehen sich, falls nichts anderes angegeben ist, auf das Gewicht.

### Beispiel 1

90 Teile eines lineares Polystyrol-Polyisopren-Polystyrol Blockcopolymer (Polystyrolgehalt 15 %, Brookfield Lösungsviskosität einer 25%igen Lösung in Toluol = 1600 mPa·s), 10 Teile Tinuvin 1130 (Gemisch aus Alpha-(3-(3-(2H-benzotriazol-2-yl)-5-(1,1-dimethylethyl)-4-hydroxyphenyl)-1-oxopropyl)-omega-hydroxy-poly(oxy-1,2-ethandiyl) und Alpha-(3-(3-(2H-benzotriazol-2-yl)-5-(1,1-dimethylethyl)-4-hydroxyphenyl)-1-oxopropyl)-omega-(3-(3-(2H-benzotriazol-2-yl)-5-(1,1-dimethylethyl)-4-hydroxyphenyl)-1-oxopropoxy)-poly(oxy-1,2-ethandiyl)), 5 Teile einer pyrogenen Kieselsäure (SiO₂-Gehalt > 99.8 %, Oberfläche nach BET 200 m²/g, Primärteilchengröße 12 nm) wurden in Toluol gelöst. Der Feststoffgehalt der Lösung betrug 28.6%. Die Viskosität betrug ca. 1600 Pa·s.
Diese Lösung wurde mit Hilfe einer feinen Pipette auf einen Teil der Seitenkanten von handelsübliche Cyrel® DPS Plattenabschnitten der Firma DuPont aufgetragen, die auf einen Zylinder aufgeklebt waren. Nach Antrocknen der Lösung wurden die Abschnitte demontiert, belichtet und ausgewaschen. Der Bereich der Seitenkanten, der durch die Lösung abgedeckt war, war frei von polymerisiertem Material. Der andere Bereich zeigte die unerwünschten Stege.

### Beispiel 2

68 Teile eines Gemisches aus einem radialen (Polystyrol-Polybutadien)₄Si Blockcopolymeren (Polystyrolgehalt 30 %, Brookfield Lösungsviskosität einer 25%igen Lösung in Toluol = 2500 mPa·s) und einem Polystyrol-Polybutadien Diblockcopolymeren (Polystyrolgehalt 25 %, Brookfield Lösungsviskosität einer 25%igen Lösung in Toluol = 2300 mPa·s) im Verhältnis 1:2, 20 Teile 2-(2-Hydroxy-3,5-di-tert.amyl-phenyl)-2H-benztriazol, 12 Teile einer pyrogenen Kieselsäure (SiO₂-Gehalt > 99.8 %, Oberfläche nach BET 200 m²/g, Primärteilchengröße 12 nm) und 0.005 Teile eines blauen Farbstoffs (C.I. 74400) wurden in einem Gemisch aus Toluol und Ethylacetat (1:1) gelöst. Der Feststoffgehalt betrug 28 %. Diese Lösung wurde wie in Beispiel 1 beschrieben verarbeitet. Der Bereich der Seitenkanten, der durch die Lösung abgedeckt war, war frei von polymerisiertem Material. Der andere Bereich zeigte die unerwünschten Stege.

## Patentansprüche

1. Verfahren zur Herstellung von Flexodruckformen wobei
a) Lasermaskenbeschichtungen enthaltende photopolymerisierbare Druckplatten auf Sleeves bzw. Zylindern vormontiert werden,
b) die Lasermasken hergestellt werden,
c) die photopolymerisierbaren Druckplatten durch diese Lasermasken belichtet werden und
d) die so belichteten Druckplatten ausgewaschen und getrocknet werden,
**dadurch gekennzeichnet, dass**
vor der Herstellung der Lasermasken in Schritt b) oder vor der bildmäßigen Belichtung der photopolymerisierbaren Druckplatten in Schritt c) ein Kantenabdeckmaterial enthaltend mindestens ein lösliches, filmbildendes Polymer, mindestens einen UV-Absorber und ein Lösemittel oder ein Lösemittelgemisch auf die Kanten der photopolymerisierbaren Druckplatten aufgebracht wird.

2. Verfahren nach Anspruch 1,
**dadurch gekennzeichnet, dass**
das Kantenabdeckmaterial als lösliche, filmbildende Polymere thermoplastisch elastomere Blockcopolymere enthält.

3. Verfahren nach Anspruch 1 oder 2,
**dadurch gekennzeichnet, dass**
das Kantenabdeckmaterial als UV-Absorber Verbindungen mit einer starken Absorption bei 360 nm enthält, die mit den filmbildenden Polymeren kompatibel sind.

4. Verfahren nach einem der Ansprüche 1 - 3,
**dadurch gekennzeichnet, dass**
das Kantenabdeckmaterial als Lösemittel Toluol, Xylol, Methylethylketon oder Ethylacetat enthält.

5. Verfahren nach einem der Ansprüche 1 - 4,
**dadurch gekennzeichnet, dass**
das Kantenabdeckmaterial zusätzlich mindestens ein Thixotropiermittel enthält.

6. Verfahren nach einem der Ansprüche 1 - 5,
**dadurch gekennzeichnet, dass**
das Kantenabdeckmaterial als Thixotropiermittel pyrogene Kieselsäuren enthält.

7. Verfahren nach einem der Ansprüche 1 - 6,
**dadurch gekennzeichnet, dass**
das Kantenabdeckmaterial einen Farbstoff und/oder ein Pigment enthält.

8. Verfahren nach einem der Ansprüche 1 - 7,
**dadurch gekennzeichnet, dass**
das Kantenabdeckmaterial eine Viskosität von 1 - 3 Pa·s hat.

9. Verfahren nach einem der Ansprüche 1 - 8,
**dadurch gekennzeichnet, dass**
das Kantenabdeckmaterial mittels einer feinen Düse längs der Kanten der photopolymerisierbaren Druckplatten aufgebracht wird.

10. Verfahren nach einem der Ansprüche 1 - 9,
**dadurch gekennzeichnet, dass**
das Kantenabdeckmaterial beim Auswaschen der belichteten Druckplatten in Schritt d) entfernt wird.

11. Photopolymerisierbare Flexodruckplatten, welche auf Sleeves bzw. Zylindern vormontiert wurden und mit einer Lasermaskenbeschichtung versehen sind,
**dadurch gekennzeichnet, dass**
auf die Kanten der photopolymerisierbaren Druckplatten ein Kantenabdeckmaterial gemäß einem der Ansprüche 1 - 10 aufgebracht wurde.

## Claims

1. Process for preparing flexographic printing forms, wherein
a) photopolymerizable printing plates bearing laser masks coatings are premounted on sleeves or cylinders,
b) the laser masks are prepared,
c) the photopolymer printing plates are exposed through these masks, and
d) the so exposed printing plates are washed off and dried,
**characterized in that**,
an edge-covering material containing at least one soluble film-forming polymer, at least one UV absorber, and a solvent or a solvent mixture is applied on the edges of the photopolymerizable printing plates before the preparation of the laser masks in step b) or before the imagewise exposure of the photopolymerizable printing plates in step c).

2. Process according to claim 1,
**characterized in that**,
the edge-covering material contains thermoplastic, elastomeric block copolymers as soluble, film-forming polymers.

3. Process according to claim 1 to 2
**characterized in that**,
the edge-covering material contains as UV absorbers compounds having high absorption at 360 nm, and which are compatible with the film-forming polymers.

4. Process according to claim 1 to 3
**characterized in that**,
the edge-covering material contains toluene, xylene, methyl ethyl ketone, or ethyl acetate as solvents.

5. Process to claim 1 to 4
**characterized in that**,
the edge-covering material additionally contains at least one thixotropic agent.

6. Process according to claim 1 to 5
**characterized in that**,
the edge-covering material contains pyrogenic silica as thixotrpic agent.

7. Process according to claim 1 to 6
**characterized in that**,
the edge-covering material contains a dye and/or a pigment.

8. Process according to claim 1 to 7
**characterized in that**,
the edge-covering material has a viscosity of 1 - 3 Pa·s.

9. Process according to claim 1 - 8,
**characterized in that**,
the edge-covering material is applied along the edges of the photopolymerizable printing plates by means of a fine nozzle.

10. Process according to claim 1 - 9,
**characterized in that**,
the edge-covering material is removed during washing-off of the exposed printing plates in step d).

11. Photopolymerizable flexographic printing plates, which have been premounted on sleeves or cylinders and which are provided with laser masks coatings,
**characterized in that**,
an edge-covering material according to claims 1 - 10 is applied along the edges of the photopolymerizable printing plates.

## Revendications

1. Procédé de préparation de formes d'impression flexographiques, dans lequel
a) des plaques d'impression photopolymérisables comportant des revêtements de masques à laser sont prémontées sur des manchons ou des cylindres,
b) les masques à laser sont préparés,
c) les plaques d'impression photopolymérisables sont exposées à travers ces masques, et
d) les plaques d'impression ainsi exposées sont lavées et séchées,
**caractérisé en ce que**
un matériau de recouvrement des bords contenant au moins un polymère soluble à formation de film, au moins un absorbeur de rayons ultraviolets et un solvant ou un mélange de solvant est appliqué sur les bords des plaques d'impression photopolymérisables avant la préparation des masques à laser lors de l'étape b) ou avant l'exposition à formation d'image des plaques d'impression photopolymérisables lors de l'étape c).

2. Procédé selon la revendication 1, **caractérisé en ce que** le matériau de recouvrement des bords contient des copolymères blocs thennoplastiques élastomères comme polymères solubles à formation de film.

3. Procédé selon les revendications 1 à 2, **caractérisé en ce que** le matériau de recouvrement des bords contient des composants à absorption des rayons ultraviolets ayant une absorption élevée à 360 mm, compatibles avec les polymères à formation de film.

4. Procédé selon les revendications 1 à 3, **caractérisé en ce que** le matériau de recouvrement des bords contient du toluène, du xylène, une méthyl-éthyl-cétone ou de l'acétate d'éthyle comme solvants.

5. Procédé selon les revendications 1 à 4, **caractérisé en ce que** le matériau de recouvrement des bords contient en plus au moins un agent thixotropique.

6. Procédé selon les revendications 1 à 5, **caractérisé en ce que** le matériau de recouvrement des bords contient de la silice pyrogène comme agent thixotropique.

7. Procédé selon les revendications 1 à 6, **caractérisé en ce que** le matériau de recouvrement des bords contient un colorant et/ou un pigment.

8. Procédé selon les revendications 1 à 7, **caractérisé en ce que** le matériau de recouvrement des bords a une viscosité comprise entre 1 et 3 Pa·s.

9. Procédé selon les revendications 1 à 8, **caractérisé en ce que** le matériau de recouvrement des bords est appliqué le long des bords des plaques d'impression photopolymérisables par l'intermédiaire d'une fine buse.

10. Procédé selon les revendications 1 à 9, **caractérisé en ce que** le matériau de recouvrement des bords est éliminé au cours du lavage des plaques d'impression exposées lors de l'étape d).

11. Plaques d'impression flexographiques photopolymérisables, ayant été prémontées sur des manchons ou des cylindres et comportant des revêtements de masques à laser, **caractérisées en ce qu'**un matériau de recouvrement des bords selon les revendications 1 à 10 est appliqué le long des bords des plaques d'impression photopolymérisables.
